# EUROPÄISCHE PATENTANMELDUNG

(11) **EP 4 322 204 A1**
(43) Veröffentlichungstag der Anmeldung: **14.02.2024**
(21) Anmeldenummer: 22189873.7
(22) Anmeldetag: 11.08.2022
(51) Int. Cl.: H01L 23/00, H01L 21/60, H01L 25/07, H01L 25/18, H01L 25/00, H01L 23/051

(54) **GESINTERTES LEISTUNGSELEKTRONISCHES MODUL**

(71) Anmelder: Siemens Aktiengesellschaft, 80333 München (DE)
(72) Erfinder: Hensler, Alexander, 91466 Gerhardshofen (DE); Pfefferlein, Stefan, 90562 Heroldsberg (DE); Strogies, Jörg, 14163 Berlin (DE); Bigl, Thomas, 91074 Herzogenaurach (DE); Heimann, Matthias, 14469 Potsdam (DE); Müller, Bernd, 16259 Falkenberg (DE); Nachtigall-Schellenberg, Christian, 14480 Potsdam (DE)
(74) Vertreter: Siemens Patent Attorneys

(57) **Zusammenfassung**

Die Erfindung betrifft ein gesintertes leistungselektronisches Modul (100) mit einer ersten Ebene (E1) und einer von der ersten Ebene (E1) verschiedenen zweiten Ebene (E2). Um ein vollständig und in mehreren Ebenen gesintertes Leistungsmodul zu ermöglichen, das in einem Arbeitsgang gesintert werden kann, werden folgende Schritte vorgeschlagen:
- ein erstes Substrat (10) mit einer ersten Metallisierung (12), die an der ersten Ebene (E1) angeordnet ist,
- ein zweites Substrat (20) mit einer zweiten Metallisierung (22), die an der zweiten Ebene (E2) angeordnet ist,
- ein oder mehrere schaltbare Dies (40), die jeweils zumindest einen ersten Leistungsanschluss (42) und zumindest einen zweiten Leistungsanschluss (44) aufweisen,
wobei die Dies (40) zwischen dem ersten Substrat (10) und dem zweiten Substrat (20) angeordnet sind und
mit dem ersten Leistungsanschluss (42) über eine erste Sinterverbindung (31) in der ersten Ebene (E1) an die erste Metallisierung (12) und mit dem zweiten Leistungsanschluss (44) über eine zweite Sinterverbindung (32) in der zweiten Ebene (E2) an die zweite Metallisierung (22) gefügt ist und wobei ein Flächeninhalt (A1) aller Sinterverbindungen (31) der ersten Ebene (E1) zwischen 90 und 110% insbesondere zwischen 95% und 105% eines Flächeninhalts (A2) aller Sinterverbindungen (32) der zweiten Ebene (E2) liegt. Die Erfindung betrifft weiterhin ein Verfahren zum Herstellen von Sinterverbindungen (31,32) eines Leistungsmoduls (100).

## Beschreibung

Die Erfindung betrifft ein gesintertes leistungselektronisches Modul sowie ein Verfahren zum Herstellen von Sinterverbindungen eines leistungselektronischen Moduls.

Ein derartiges Leistungsmodul kommt beispielsweise in Umrichtern in der Industrie sowie in Elektrofahrzeugen zum Einsatz.

Aufbausysteme der Leistungselektronik mit verschiedenen Fügebenen können zur Erlangung elektrisch/thermischer und mechanischer Verbindungen metallurgisch gefügt werden. Aus konstruktiven und fertigungsgemäßen Anforderungen werden zur Realisierung dieser Fügeebenen primär Drucksinterverbindungen aus Ag bzw. Weichlötverbindungen angewandt. Drucksinterverbindungen besitzen hinsichtlich ihrer elektrischen und Hochtemperatureigenschaften bevorzugte Eigenschaften. Herausfordernd ist die notwendige Prozessierung unter Anwendung von mechanischem Druck, typisch im Bereich von etwa 10 - 20 MPa, und der Notwendigkeit erhöhter Temperaturen. Bei der Sinterung in mehreren Ebenen und komplexeren Aufbauten besteht die Anordnung aus hinsichtlich der Kraft/des Drucks parallel und/oder in Serie liegenden wirksamen Fügezonen.

Der Erfindung liegt die Aufgabe zugrunde, ein vollständig und in mehreren Ebenen gesintertes Leistungsmodul zu ermöglichen, das in einem Arbeitsgang gesintert werden kann.

Diese Aufgabe wird durch ein gesintertes Leistungsmodul mit den im Anspruch 1 angegebenen Merkmalen gelöst.

Das gesinterte leistungselektronisches Modul mit einer ersten Ebene und einer von der ersten Ebene verschiedenen zweiten Ebene, weist dabei ein erstes Substrat mit einer ersten Metallisierung, die an der ersten Ebene angeordnet ist, ein zweites Substrat mit einer zweiten Metallisierung, die an der zweiten Ebene angeordnet ist, und ein oder mehrere schaltbare Dies auf, die jeweils zumindest einen ersten Leistungsanschluss und zumindest einen zweiten Leistungsanschluss aufweisen. Die Dies sind dabei zwischen dem ersten Substrat und dem zweiten Substrat angeordnet und jeweils mit dem ersten Leistungsanschluss über eine erste Sinterverbindung in der ersten Ebene an die erste Metallisierung und mit dem zweiten Leistungsanschluss über eine zweite Sinterverbindung in der zweiten Ebene an die zweite Metallisierung gefügt. Damit sich ein im tolerierbaren Bereich konstanter Druck beim Sintern einstellt liegt vorteilhaft ein Flächeninhalt aller Sinterverbindungen der ersten Ebene zwischen 90 und 110%, insbesondere zwischen 95% und 105% eines Flächeninhalts aller Sinterverbindungen der zweiten Ebene. Das so definierte Leistungsmodul ist in einem Prozessschritt sinterbar und kann folglich einfacher gefertigt werden.

Als Flächeninhalt ist die bezüglich eines Drucks in der Fläche relevante Querschnittsfläche der Sinterverbindung zu verstehen. Es können also vereinfacht die Querschnittsflächen der Sinterverbindungen verwendet werden. Da die beim Sintern verwendeten Pressen kraftgesteuert sind, ist es wichtig, dass das Modul entsprechend konstruktiv ausgestaltet ist, dass die in den Sinterverbindungen bzw. deren Vorläufer-Sintermaterialien entstehenden Drücke zu einer qualitativ hochwertigen Sinterverbindung führen. Eine Angleichung der Flächeninhalte der Sinterverbindungen führt bei konstanter Krafteinwirkung auf das gesamte Modul bzw. den Stapel zu einer gleichmäßigen Druckverteilung in den einzelnen Sinterverbindungen.

Der schaltbare Die ist ein Halbleiterbauelement, der beispielsweise als IGBT oder MOSFET ausgebildet sein kann. Es handelt sich dabei um einen ungehäusten Halbleiter und wird auch als Bare Die oder als Nacktchip bezeichnet. Vorzugsweise kommen dabei sogenannte "wide bandgap" Halbleiter zum Einsatz. Die Substrate können dabei ein Metall-Keramik-Substrat ausgebildet sein. Insbesondere sind hier die sogenannten Direct-Bonded-Copper und Active Metal Brazing Substrate zu nennen. Weiterhin ist es möglich Kunststoffleiterplatten für eines der Substrate zu verwenden, z.B. faserverstärkte Kunststoffleiterplatten, wie FR4-Leiterplatten, sogenannte Hoch-Tg-PCBs (aufweisend eine Glasübergangstemperatur TG von größer als 150°C), aus Polyimid und/oder als pre-molded leadframe ausgestaltet. Für Hochtemperaturanwendungen haben sich Hochtemperatur-Interposer Materialien wie beispielsweise PI, PEEK oder LCP bewährt.

In einer weiteren Ausführungsform weist das leistungselektronische Modul zumindest eine elektrisch leitende Umkontaktierung auf die ein elektrisches Potential der ersten Ebene mit der zweiten Ebene verbindet. Die Umkontaktierung ist über Ausgleichs-Sinterverbindungen, die einen untereinander verschiedenen Flächeninhalt aufweisen, mit der ersten und der zweiten Metallisierung kontaktiert. Vorteilhaft können so Flächenunterschiede der Sinterverbindungen in der ersten und der zweiten Ebene ausgeglichen werden, sodass sich ein gleichmäßiger Druck in beiden Ebenen einstellt und die Sinterverbindungen dementsprechend eine hohe Qualität aufweisen.

In einer weiteren Ausführungsform weist die Umkontaktierung eine erste Kontaktfläche und eine zweite Kontaktfläche auf, die einen voneinander verschiedenen Flächeninhalt aufweisen. So kann die Umkontaktierung mit ihrer Form zu einer besseren Kraftführung beitragen und in die unterschiedlich großen Sinterverbindungen die Kraft besser einleiten.

In einer weiteren Ausführungsform weist das leistungselektronische Modul zumindest zwei schaltbare Dies auf, die jeweils Sinterverbindungen zu den Metallisierungen aufweisen. Besonders vorteilhaft ist die Architektur, wenn mehrere Dies angeordnet werden, da so eine optimale Verteilung des Drucks erreicht werden kann und die für den Anwendungszweck notwendige Anzahl von Dies gesintert werden.

In einer weiteren Ausführungsform weist das leistungselektronische Modul zumindest zwei schaltbare Dies mit Steueranschlüssen auf. Bezüglich der Steueranschlüsse und der daran angrenzenden Ebene sind die Dies verschieden angeordnet. In anderen Worten können die Dies jeweils mit Ober- und Unterseite abwechselnd angeordnet sein. Dabei muss nicht unmittelbar abwechselnd ein Wechsel stattfinden, Ziel ist es, dass die Dies so angeordnet sind, dass der Flächeninhalt der Sinterverbindungen in der ersten Ebene möglichst dem Flächeninhalt der Sinterverbindungen in der zweiten Ebene entspricht. Da Chip-Ober- und -Unterseite voneinander abweichende Kontaktflächen aufweisen ist das Abwechseln der Chipausrichtung eine Möglichkeit hier den Flächeninhalt der Sinterverbindungen weiter anzugleichen.

In einer weiteren Ausführungsform weist das leistungselektronische Modul ein oder mehrere elektrisch isolierende Ausgleichselemente auf, die derart angeordnet sind, dass die Summe aus Flächeninhalten aller Sinterverbindungen und der Ausgleichselemente in der ersten Ebene der Summe der Flächeninhalte aller Sinterverbindungen und der Ausgleichselemente in der zweiten Ebene unter Berücksichtigung einer Abweichung von maximal 10% entspricht. Die elektrisch isolierenden Ausgleichselemente können so die Flächen weiter angleichen, da auf diese ebenso wie auf die Sinterverbindungen der sich durch die Kraft und die Flächen einstellende Druck wirkt. Die Ausgleichselemente können dabei durch beide Ebenen hindurchragen und mit beiden Metallisierungen der Substrate in mechanischem Kontakt stehen.

In einer weiteren Ausführungsform weist das leistungselektronische Modul eine von der ersten Ebene und der zweiten Ebene verschiedene dritten Ebene auf. In der dritten Ebene kontaktieren dritte Sinterverbindungen eine zweite Metallisierung des zweiten Substrats mit Anschlusselementen. Die Anschlusselemente können dabei metallische Anschlusselemente zur thermischen und/oder elektrischen Kontaktierung des Moduls mit Kühlkörpern oder Leistungsanschlüssen sein.

In einer weiteren Ausführungsform sind die Sinterverbindungen als Drucksinterverbindungen ausgebildet. Drucksinterverbindungen lassen sich durch den Aufbau des Moduls besonders vorteilhaft in einem Arbeitsgang in mehreren Ebenen herstellen. Als Sintermaterialien kommen hier z.B. silberbasierte Drucksinterpasten und Preforms in Frage.

Die Aufgabe wird weiterhin durch ein Verfahren zum Herstellen von Sinterverbindungen eines leistungselektronischen Moduls in Form eines Stapels in zumindest einer ersten Ebene und einer von der ersten Ebene verschiedenen zweiten Ebene gelöst. Das Verfahren umfasst die Schritte:
- Bereitstellen eines ersten Substrats mit einer ersten Metallisierung, die an der ersten Ebene angeordnet ist, eines zweiten Substrats mit einer zweiten Metallisierung, die an der zweiten Ebene angeordnet ist und ein oder mehrerer schaltbarer Dies, die zwischen dem ersten Substrat und dem zweiten Substrat angeordnet sind und jeweils zumindest einen ersten Leistungsanschluss und zumindest einen zweiten Leistungsanschluss aufweisen.
- Bereitstellen von Sintermaterial in der ersten Ebene, das die ersten Leistungsanschlüsse an die erste Metallisierung kontaktiert und von Sintermaterial in der zweiten Ebene, das den zweiten Leistungsanschluss an die zweite Metallisierung kontaktiert. Ein Flächeninhalt des Sintermaterials in der ersten Ebene entspricht dabei mindestens 90% und höchstens 110%, insbesondere 95% bis 105%, eines Flächeninhalts des Sintermaterials in der zweiten Ebene.
- Aufbringen einer Kraft bei einer Temperatur auf den Stapel, sodass sich in den Sintermaterialien der ersten und der zweiten Ebene ein Druck einstellt, der zum Ausbilden von ersten und zweiten Sinterverbindungen aus den Sintermaterialien führt. Die Sinterverbindungen in den unterschiedlichen Ebenen können dabei gleichzeitig oder überschneidend mit leichtem Versatz ausgebildet werden.

Das Sintermaterial kann dabei als Preform, als Siebdruck oder in weiteren üblichen Darreichungsformen aufgebracht sein.

Beim Aufbringen der Kraft, z.B. durch eine Sinterpresse, stellt sich so abhängig von den Querschnittsflächen der Sintermaterialien ein Druck in den einzelnen Sinterverbindungen ein. Durch das erfindungsgemäße Verfahren ist der Druck durch die Annäherung der Flächeninhalte in beiden Ebenen ähnlich groß, womit ein Fertigstellen und eine hohe Qualität der Sinterverbindungen in beiden Ebenen garantiert werden.

Die Ausführungsformen des leistungselektronischen Moduls sind dabei insbesondere bzgl. der Anordnung der Sinterverbindungen (bzw. des Sintermaterials im Zustand vor dem Fügen) und der Fläche des Sintermaterials in den Ebenen auf das Verfahren anwendbar. Das Verfahren dient dabei insbesondere zum Erzeugen eines leistungselektronischen Moduls nach ein oder mehreren der Ausführungsformen, wie sie eingangs beschrieben sind.

In einer weiteren Ausführungsform wird die Kraft derart eingestellt, dass sich in den Sintermaterialien der ersten und der zweiten Ebene ein Druck von zumindest 10 MPa, insbesondere zumindest 15 MPa einstellt. Ein Druckbereich von 10 bis 20 MPa kann dabei als üblich angesehen werden. Wird ein mittlerer Bereich von ca. 15 MPa (12 bis 18 MPa) gewählt, so können größere Flächenabweichungen toleriert werden und die Sinterverbindungen werden sowohl zufriedenstellen ausgebildet und die Dies keinem zu großem Druck ausgesetzt. Ein Temperaturbereich um die 250°C (220 bis 280°C) hat sich als vorteilhaft erwiesen.

In einer weiteren Ausführungsform ist der Flächeninhalt des Sintermaterials in der ersten Ebene und in der zweiten Ebene so gewählt, dass sich der Druck in den Ebenen um maximal 1 MPa unterscheidet. Durch den Zusammenhang von Fläche, Kraft und Druck kann der Druck in den Ebenen so eingestellt werden, dass sich dieser nur um zulässige Werte unterscheidet. Anforderungen an die Sinterpresse können so verringert werden.

In einer weiteren Ausführungsform wird die Kraft mit einem Stempel auf den gesamten Stapel aufgebracht. Durch die vorteilhafte Anordnung des Stapels und die Dimensionierung der Sintermaterialien kann der gesamte Stapel in einem einzigen Pressvorgang gesintert werden.

In einer weiteren Ausführungsform werden vor dem Aufbringen der Kraft Ausgleichselemente derart angeordnet, dass eine Vorwölbung von zumindest einem der Substrate verringert wird. Erstreckt sich eines der Substrate über eine größere Fläche als das weitere Substrat, so können temporär für den Pressvorgang Ausgleichselemente angeordnet werden. Diese Ausgleichselemente sind vorzugsweise so anzuordnen, dass diese einseitig unmittelbar mit der Presse in Verbindung stehen. Eine gleichmäßige Kraftverteilung auf Teile des Moduls, die nicht unmittelbar in der Presse in mechanischer Verbindung stehen kann so gewährleistet werden.

In einer weiteren Ausführungsform wird die Kraft F zum Herstellen der Sinterverbindungen kontinuierlich aufgebracht, bis die Sinterverbindungen beiden Ebenen fertiggestellt sind. In anderen Worten kann die Kraft F ohne abzusetzen auf den gesamten Stapel aufgebracht werden und die Sinterverbindungen werden in allen Ebenen durch den mit den Flächeninhalten einstellbaren Druck fertiggestellt.

In einer weiteren Ausführungsform vergehen vom Aufbringen der Kraft F bis zum Fertigstellen aller Sinterverbindungen () in allen Ebenen maximal 180s. Durch das Verfahren kann die Prozesszeit zum Fertigstellen von Sinterverbindungen erheblich verkürzt werden, da nicht nur die Zwischenschritte nach dem Sintern in einer einzigen Ebene eingespart werden können, wie erneutes aufbringen von Sintermaterial, sondern auch die sequentiellen Dauern des eigentlichen Sintervorgangs. Es ist denkbar, dass der Sintervorgang in mehreren Ebenen etwas länger dauert als in einer einzigen Ebene, der Zeitvorteil ist aber dennoch enorm.

Im Folgenden wird die Erfindung anhand der in den Figuren dargestellten Ausführungsbeispiele näher beschrieben und erläutert. Es zeigen:
- FIG 1: eine Ausführungsform eines leistungselektronischen Moduls,
- FIG 2: einen Schnitt durch die erste Ebene in der Draufsicht,
- FIG 3: einen Schnitt durch die zweite Ebene in der Draufsicht,
- FIG 4: eine weitere Ausführungsform des leistungselektronischen Moduls in einer Sinterpresse und
- FIG 5: einen Kraftverlauf im leistungselektronischen Modul im gepressten Zustand.

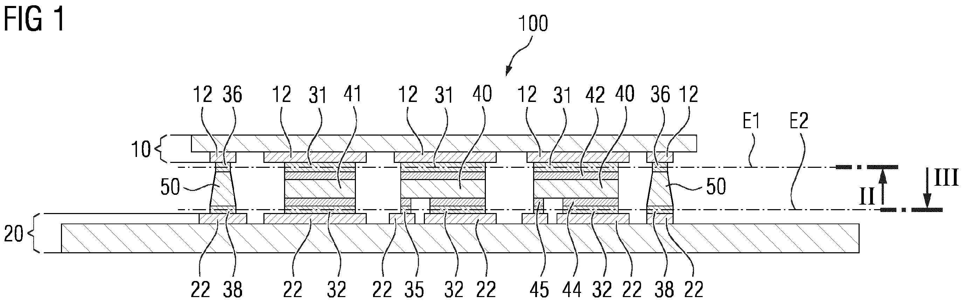

FIG 1 zeigt ein Ausführungsbeispiel eines leistungselektronischen Moduls 100, mit einer ersten Ebene E1 und einer von der ersten Ebene E1 verschiedenen zweiten Ebene E2. Die Ebenen E1 und E2 sind dabei parallel zu einem ersten Substrat 10 und einem zweiten Substrat 20 des Moduls 100 angeordnet. Das erste Substrat 10 weist eine ersten Metallisierung 12 auf, die an der ersten Ebene E1 angeordnet ist und einer zweiten Metallisierung 22 des zweiten Substrats 20 zugewandt angeordnet ist. Das zweite Substrat 20 ist mit seiner zweiten Metallisierung 22 an der zweiten Ebene E2 angeordnet. Zwischen den Metallisierungen 12,22 sind vorliegend zwei schaltbare Dies 40 angeordnet, die jeweils einen ersten Leistungsanschluss 42 und einen zweiten Leistungsanschluss 44 aufweisen. Die Dies 40 weisen jeweils einen Steueranschluss 45 auf. Die ersten Leistungsanschlüsse 42 sind dabei über erste Sinterverbindungen 31 mit der ersten Metallisierung 12 verbunden. Die erste Metallisierung 12 ist so strukturiert, dass die elektrischen Bauelemente eine funktionale Einheit bilden können. Beispielsweise sind Fügeflächen auf der Metallisierung vorgesehen. Analog sind die zweiten Leistungsanschlüsse 44 über zweite Sinterverbindungen 32 mit der zweiten Metallisierung 22 verbunden. Die zweite Metallisierung ist ebenso strukturiert. Die Steueranschlüsse 45 sind vorliegend über Fügeverbindungen 35 an die zweite Metallisierung 22 gefügt. Die Steueranschlüsse könnten aber ebenso an die erste Metallisierung 12 oder unterschiedlich an erste und zweite Metallisierung 12,22 gefügt sein. Die Fügeverbindungen können je nach Größe auch gesintert werden oder als Lotverbindung ausgestaltet sein, die beim Sintern mit entsteht.

Beispielsweise kann das Leistungsmodul 100 als Halbbrücke, Vollbrücke oder sog. Sixpack, jeweils mit einem oder mehreren Dies 40 pro funktionalem Schalter (z.B. abhängig davon, ob MOSFETs oder IGBT zum Einsatz kommen) ausgebildet sein. Ein weiteres elektronisches Bauelement 41 weist zwei Anschlüsse auf und ist ebenso wie die Dies 40 zwischen den Metallisierungen 12,22 angeordnet.

Die Dies 40 und das weitere elektronische Bauelement 41 sind jeweils über Sinterverbindungen mit den Substraten 10,20 bzw. deren Metallisierungen 12,22 verbunden.

Weiterhin sind elektrisch leitende Umkontaktierungen 50 mit Ausgleichs-Sinterverbindungen 36,38 so angeordnet, dass ein Flächeninhalt aller Sinterverbindungen in der ersten Ebene E1 an den Flächeninhalt aller Sinterverbindungen in der zweiten Ebnee E2 annähert. Im vorliegenden Fall ist die oberhalb der Umkontaktierung 50 angeordnete Ausgleichs-Sinterverbindung 36 kleiner ausgestaltet als die unterhalb der Umkontaktierung 50 angeordnete Ausgleichs-Sinterverbindung 38. Die Ausgleichs-Sinterverbindungen 36,38 können in der Größe frei gewählt werden, wenn diese die erforderliche Mindestgröße (z.B. durch die Stromtragfähigkeit vorgegeben) überschreiten. Die Umkontaktierung 50 kann dabei ein Kupferformteil sein, das z.B. als Quader oder als Pyramidenstumpf bzw. Polyeder mit zumindest zwei parallelen Fügeflächen ausgebildet sein kann. Die Größe der Ausgleichs-Sinterverbindungen 36,38 muss dabei nicht der Größe der Flächen der Umkontaktierung entsprechen, auf denen sie aufliegen, sondern können auch kleiner gewählt sein.

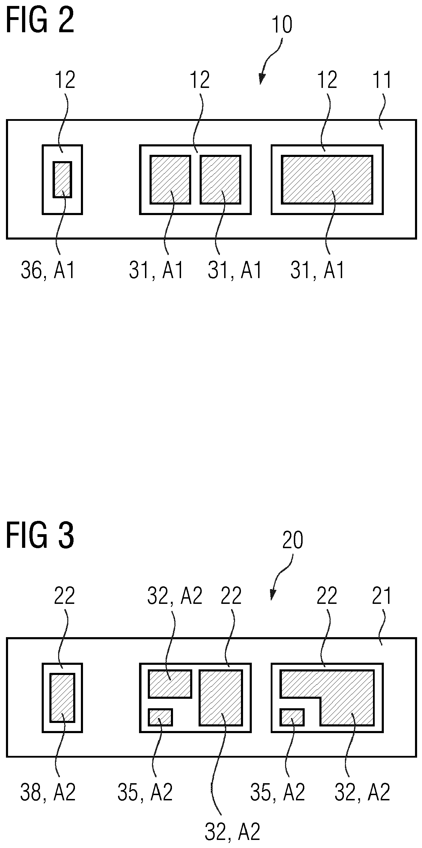

FIG 2 zeigt schematisch einen Schnitt durch die erste Ebene E1 des leistungselektronischen Moduls 100 in der Draufsicht, wobei das erste Substrat 10 aus einem Substratmaterial 11 mit seiner ersten Metallisierung 12 und den daraus gebildeten Fügeflächen zu sehen ist. Der Einfachheit halber sind nur Fügeflächen einer der Umkontaktierungen 50 und der beiden Dies 40 aus FIG 1 zu sehen. Auf der Metallisierung 12 sind die ersten Sinterverbindungen 31, der Leistungsanschlüsse der Dies 40 sowie die Ausgleichs-Sinterverbindung 36 zu sehen. Alle Sinterverbindungen 31,36 tragen zum Flächeninhalt A1 der Sinterverbindungen bei, da sich dort durch die Kraft der Sinterpresse ein Druck einstellt, der die Sinterverbindungen aus den verwendeten Sintermaterialien erstellt.

Die mittlere Fügefläche der Metallisierung 12 weist dabei zwei voneinander getrennte Sinterverbindungen 31 auf, die entsprechend den ersten Leistungsanschlüssen 42 dies jeweiligen Dies 40 ausgestaltet sind. Dies weisen oftmals getrennte Flächen für die Leistungsanschlüsse auf, die auf demselben Potential liegen. Dies ist abhängig von der Bauform und dem Fabrikat der Dies.

Die Ausgleichs-Sinterverbindung 36 hat im Vergleich zur Vorhandenen Fügefläche der Metallisierung 12 eine kleinere Fläche, dies zeigt, dass hier eine Anpassung der Fläche A1 der Sinterverbindungen stattfinden kann.

FIG 3 zeigt schematisch und analog zu FIG 2 einen Schnitt durch die zweite Ebene E2 des leistungselektronischen Moduls 100 in der Draufsicht, wobei das zweite Substrat 20 aus einem Substratmaterial 21 mit seiner zweiten Metallisierung 12 und den daraus gebildeten Fügeflächen zu sehen ist. Zweite Sinterverbindungen 32, eine Ausgleichs-Sinterverbindung 38 und eine Fügeverbindung 35 eines Steueranschlusses (z.B. Gate oder Kollektor) des Dies 40 tragen zur zweiten Fläche A2 bei.

Es ist zu sehen, dass die zweiten Sinterverbindungen 32 wegen der Bauart der Dies 40 und auch wegen der Fügeverbindungen 35 der Steueranschlüsse 45 eine kleinere Fläche aufweisen als die ersten Sinterverbindungen 31 auf der anderen Seite des Dies, also in Ebene E1, wie in FIG 2 gezeigt. Die mittlere Fügefläche weist dabei zwei zweite Fügeverbindungen 32 auf, derartig aufgeteilte Leistungsanschlüsse sind bei manchen Dies üblich. Die rechte Fügefläche der Metallisierung 22

Weiterhin ist zu sehen, dass die Ausgleichs-Sinterverbindung 38 in der zweiten Ebene E2, eine größere Fläche aufweist als die Ausgleichs-Sinterverbindung 36 der FIG 2 in der ersten Ebene E1.

Es ist somit durch Wählen der Flächen der Ausgleichs-Sinterverbindungen 36,38 ergänzend oder alternativ zu einem Anordnen der Dies und weiteren Bauteile möglich, die Flächeninhalte A1, A2 der Sinterverbindungen in den Ebenen E1,E2 aneinander anzugleichen. Dies führt vorteilhaft dazu, dass

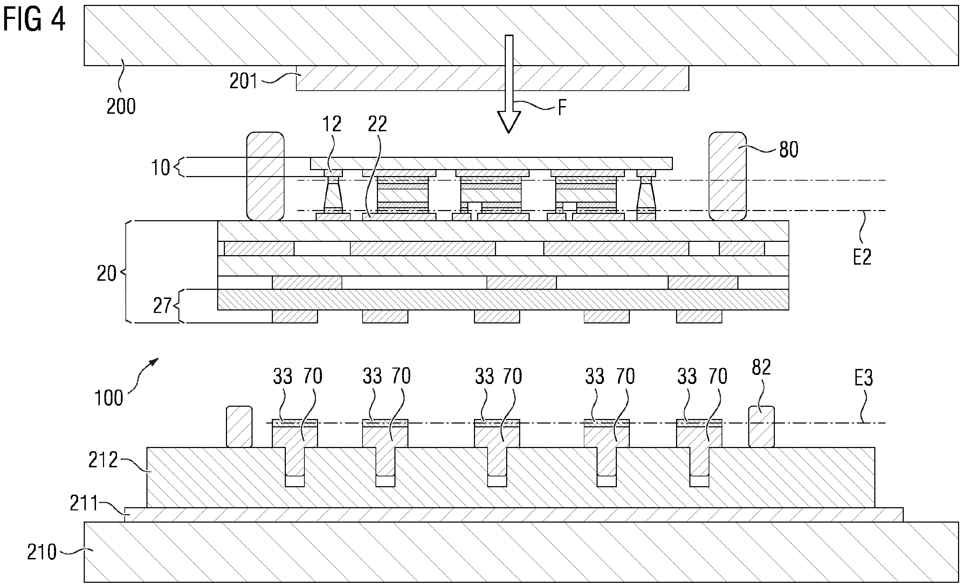

FIG 4 zeigt eine weitere Ausführungsform des leistungselektronischen Moduls 100 zwischen den Werkzeugen einer Sinterpresse. Das leistungselektronische Modul 100 basiert dabei auf der in FIG 1 gezeigten Ausführungsform und wurde am zweiten Substrat 20 erweitert.

Die Sinterpresse weist dabei einen Stempel 200 mit einer Auflage 201 auf, der eine Kraft F von oben auf das Modul 100 ausüben soll.

Das zweite Substrat 20 weist mehrere Lagen und eine zweite Metallisierung 27 auf. Die zweite Metallisierung 27 dient dabei zur Anbindung von Anschlusselementen 70, die in einer dritten Ebene E3 durch dritte Sinterverbindungen 33 an die zweite Metallisierung 27 gefügt sind. Die Anschlusselemente 70 sind im vorliegenden Fall als Metallstifte ausgebildet, die sowohl thermisch als auch elektrische Verbindungen bereitstellen können. Die Pins können dabei beispielsweise eingepresst werden.

Ein unteres Werkzeug 210 dient als Gegenstück zum Stempel 200 und weist eine Adapterplatte 212, die auf einer Auflage 211 gelagert ist, auf. Die Adapterplatte weist in diesem Fall Aussparungen auf, die an das zweite Substrat 20, bzw. die daran angebrachten Anschlusselemente 70 angepasst ist.

Die dritten Sinterverbindungen 33 in der dritten Ebene E3 weisen dabei einen Flächeninhalt auf, der von den Flächeninhalten A1, A2 der Sinterverbindungen 31,32 in der ersten und der zweiten Ebene E1,E2 verschieden sein kann. Der Unterschied der Flächeninhalte würde zu einem Unterschied im Druck beim Drucksintern führen, sodass im vorliegenden Beispiel Ausgleichselemente 80, 82 vorgesehen sind. Die Ausgleichselemente können dabei zum gleichmäßigeren Verteilen der Kraft F auf die Fläche zum Einsatz kommen. Erste Ausgleichselemente 80 stehen dabei im geschlossenen Zustand der Sinterpresse nur mit dem Stempel 200 und der dem Stempel 200 zugewandten Seite des zweiten Substrats 20 in Kontakt. Die Flächeninhalte der Querschnitte der Ausgleichselemente 80,82 in den verschiedenen Ebenen E1,E2,E3 können dabei zur Angleichung der Summe der Flächeninhalte in der jeweiligen Ebene an die weiteren Ebenen und damit zur Angleichung des Drucks beim Fügen verwendet werden. Darüber hinaus kann vorteilhaft auch Wölbungen bei unterschiedlich großen ersten und zweiten Substraten 10,20 vermieden oder verringert werden.

Analog zu den ersten Ausgleichselementen 80 sind zweite Ausgleichselemente 82 unterhalb des zweiten Substrats 20 angeordnet, um einen Überhang, den das zweite Substrat 20 hinsichtlich der Anschlusselemente 70 aufweist zu verringern. Die Ausgleichselemente können dabei mehrfach verwendet werden und müssen nicht auf dem leistungselektronischen Modul 100 verbleiben. Es ist denkbar, dass Ausgleichselemente (nicht gezeigt) derart angeordnet und eingebunden werden, dass sie auf/in dem Modul 100 verbleiben können.

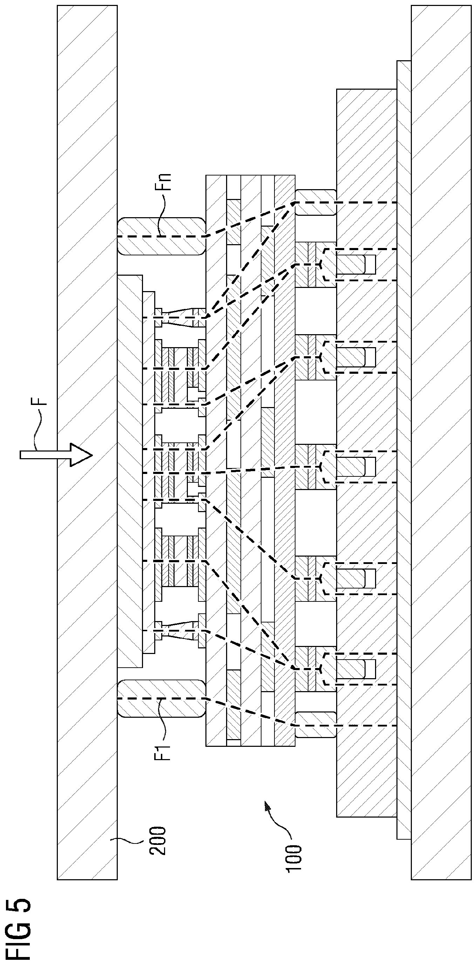

FIG 5 zeigt nun die Ausführungsform aus FIG 4, wobei die Sinterpresse geschlossen ist. Der Stempel 200 presst also mit einer Kraft F auf das Leistungselektronische Modul 100. Die Aufteilung der Kraft F in einzelne Kraft-Pfade F1,...,Fn, die gestrichelt eingezeichnet sind, definiert dabei den jeweilig entstehenden Druck. Die Krafteinleitung kann durch die in dieser Erfindung offenbarten konstruktiven und verfahrenstechnischen Maßnahmen optimiert werden, sodass ein Drucksintern in mehreren Ebenen verbessert wird. Es stellt sich eine erhebliche Zeitersparnis im Vergleich zum sequenziellen Sintern ein.

Zusammenfassend betrifft die Erfindung ein gesintertes leistungselektronisches Modul 100 mit einer ersten Ebene E1 und einer von der ersten Ebene E1 verschiedenen zweiten Ebene E2. Um ein vollständig und in mehreren Ebenen gesintertes Leistungsmodul zu ermöglichen, das in einem Arbeitsgang gesintert werden kann, werden folgende Schritte vorgeschlagen:
- ein erstes Substrat 10 mit einer ersten Metallisierung 12, die an der ersten Ebene E1 angeordnet ist,
- ein zweites Substrat 20 mit einer zweiten Metallisierung 22, die an der zweiten Ebene E2 angeordnet ist,
- ein oder mehrere schaltbare Dies 40, die jeweils zumindest einen ersten Leistungsanschluss 42 und zumindest einen zweiten Leistungsanschluss 44 aufweisen,
wobei die Dies 40 zwischen dem ersten Substrat 10 und dem zweiten Substrat 20 angeordnet sind und
mit dem ersten Leistungsanschluss 42 über eine erste Sinterverbindung 31 in der ersten Ebene E1 an die erste Metallisierung 12 und mit dem zweiten Leistungsanschluss 44 über eine zweite Sinterverbindung 32 in der zweiten Ebene E2 an die zweite Metallisierung 22 gefügt ist und wobei ein Flächeninhalt A1 aller Sinterverbindungen 31 der ersten Ebene E1 zwischen 90 und 110% insbesondere zwischen 95% und 105% eines Flächeninhalts A2 aller Sinterverbindungen 32 der zweiten Ebene E2 liegt. Die Erfindung betrifft weiterhin ein Verfahren zum Herstellen von Sinterverbindungen 31,32 eines Leistungsmoduls 100.

### Bezugszeichenliste

- 100: gesintertes leistungselektronisches Modul
- 10, 20: erstes / zweites Substrat
- 11: Substratmaterial
- 12, 22: Metallisierung des ersten / zweiten Substrats
- 27: zweite Metallisierung des zweiten Substrats
- 31: erste Sinterverbindungen
- 32: zweite Sinterverbindungen
- 33: dritte Sinterverbindungen
- 35: Fügeverbindung des Steueranschlusses
- 36,38: Ausgleichs-Sinterverbindungen
- 40: schaltbarer Die
- 42,44: Leistungsanschlüsse des Dies
- 45: Steueranschluss des Dies
- 50: Umkontaktierung
- 70: Anschlusselemente
- 80,82: Ausgleichselemente
- E1, E2: erste und zweite Ebene
- A1, A2: Flächeninhalt aller Sinterverbindungen in der ersten bzw. zweiten Ebene
- F1,...,Fn: Kraft-Pfade
- 200: Stempel einer Sinterpresse
- 201: Auflage des Stempels
- 210: Unteres Werkzeug der Sinterpresse
- 211: Auflage des unteren Werkzeugs
- 212: Adapterplatte für das untere Werkzeug

## Patentansprüche

1. Gesintertes leistungselektronisches Modul (100) mit einer ersten Ebene (E1) und einer von der ersten Ebene (E1) verschiedenen zweiten Ebene (E2), aufweisend:
- ein erstes Substrat (10) mit einer ersten Metallisierung (12), die an der ersten Ebene (E1) angeordnet ist,
- ein zweites Substrat (20) mit einer zweiten Metallisierung (22), die an der zweiten Ebene (E2) angeordnet ist,
- ein oder mehrere schaltbare Dies (40), die jeweils zumindest einen ersten Leistungsanschluss (42) und zumindest einen zweiten Leistungsanschluss (44) aufweisen,
wobei die Dies (40) zwischen dem ersten Substrat (10) und dem zweiten Substrat (20) angeordnet sind und
mit dem ersten Leistungsanschluss (42) über eine erste Sinterverbindung (31) in der ersten Ebene (E1) an die erste Metallisierung (12) und mit dem zweiten Leistungsanschluss (44) über eine zweite Sinterverbindung (32) in der zweiten Ebene (E2) an die zweite Metallisierung (22) gefügt ist und wobei ein Flächeninhalt (A1) aller Sinterverbindungen (31) der ersten Ebene (E1) zwischen 90 und 110% insbesondere zwischen 95% und 105% eines Flächeninhalts (A2) aller Sinterverbindungen (32) der zweiten Ebene (E2) liegt.

2. Leistungselektronisches Modul (100) nach Anspruch 1, ferner aufweisend zumindest eine elektrisch leitende Umkontaktierung (50) die ein elektrisches Potential der ersten Ebene (E1) mit der zweiten Ebene (E2) verbindet, wobei die Umkontaktierung (50) über Ausgleichs-Sinterverbindungen (36,38), die einen untereinander verschiedenen Flächeninhalt aufweisen, mit der ersten und der zweiten Metallisierung (12,22) kontaktiert ist.

3. Leistungselektronisches Modul (100) nach Anspruch 2, wobei die Umkontaktierung (50) eine erste Kontaktfläche und eine zweite Kontaktfläche aufweist, die einen voneinander verschiedenen Flächeninhalt aufweisen.

4. Leistungselektronisches Modul (100) nach einem der vorhergehenden Ansprüche, aufweisend zumindest zwei schaltbare Dies (40), die jeweils Sinterverbindungen (31,32) zu den Metallisierungen (12,22) aufweisen.

5. Leistungselektronisches Modul (100) nach einem der vorhergehenden Ansprüche, aufweisend zumindest zwei schaltbare Dies (40) mit Steueranschlüssen (45), die bezüglich ihrer Steueranschlüsse (45) und der daran angrenzenden Ebene (E1,E2) verschieden angeordnet sind.

6. Leistungselektronisches Modul (100) nach einem der vorhergehenden Ansprüche, aufweisend ein oder mehrere elektrisch isolierende Ausgleichselemente, die derart angeordnet sind, dass die Summe aus Flächeninhalten aller Sinterverbindungen (32) und der Ausgleichselemente in der ersten Ebene (E1) der Summe der Flächeninhalte aller Sinterverbindungen (32) und der Ausgleichselemente in der zweiten Ebene (E2) unter Berücksichtigung einer Abweichung von maximal 10% entspricht.

7. Leistungselektronisches Modul (100) nach einem der vorhergehenden Ansprüche, mit einer von der ersten Ebene (E1) und der zweiten Ebene (E2) verschiedenen dritten Ebene (E3), wobei in der dritten Ebene (E3) dritte Sinterverbindungen (33) Anschlusselemente (70) mit einer zweiten Metallisierung (27) des zweiten Substrats (20) kontaktieren.

8. Leistungselektronisches Modul (100) nach einem der vorhergehenden Ansprüche, wobei die Sinterverbindungen (31,32) als Drucksinterverbindungen ausgebildet sind.

9. Verfahren zum Herstellen von Sinterverbindungen eines leistungselektronischen Moduls (100) in Form eines Stapels in zumindest einer ersten Ebene (E1) und einer von der ersten Ebene (E1) verschiedenen zweiten Ebene (E2), umfassend die Schritte:
- Bereitstellen eines ersten Substrats (10) mit einer ersten Metallisierung (12), die an der ersten Ebene (E1) angeordnet ist, eines zweiten Substrats (20) mit einer zweiten Metallisierung (22), die an der zweiten Ebene (E2) angeordnet ist und ein oder mehrerer schaltbarer Dies (40), die zwischen dem ersten Substrat (10) und dem zweiten Substrat (20) angeordnet sind und jeweils zumindest einen ersten Leistungsanschluss (42) und zumindest einen zweiten Leistungsanschluss (44) aufweisen,
- Bereitstellen von Sintermaterial in der ersten Ebene (E1), das die ersten Leistungsanschlüsse (42) an die erste Metallisierung (12) kontaktiert und
von Sintermaterial in der zweiten Ebene (E2), das den zweiten Leistungsanschluss (44) an die zweite Metallisierung (22) kontaktiert,
wobei ein Flächeninhalt des Sintermaterials in der ersten Ebene (E1) mindestens 90% und höchstens 110% eines Flächeninhalts des Sintermaterials in der zweiten Ebene (E2) entspricht, und
- Aufbringen einer Kraft (F) bei einer Temperatur (T) auf den Stapel, sodass sich in den Sintermaterialien der ersten und der zweiten Ebene (E1,E2) ein Druck einstellt, der zum Ausbilden von ersten und zweiten Sinterverbindungen (31,32) aus den Sintermaterialien führt.

10. Verfahren nach Anspruch 9, wobei die Kraft (F) derart eingestellt wird, dass sich in den Sintermaterialien der ersten und der zweiten Ebene (E1,E2) ein Druck von zumindest 10 MPa, insbesondere zumindest 15 MPa einstellt.

11. Verfahren nach Anspruch 9 oder 10, wobei der Flächeninhalt des Sintermaterials in der ersten Ebene (E1) und in der zweiten Ebene (E2) so gewählt ist, dass sich der Druck in den Ebenen (E1, E2) um maximal 1 MPa unterscheidet.

12. Verfahren nach einem der Ansprüche 9 bis 11, wobei die Kraft (F) mit einem Stempel (200) auf den gesamten Stapel aufgebracht wird.

13. Verfahren nach einem der Ansprüche 9 bis 12, wobei vor dem Aufbringen der Kraft (F) Ausgleichselemente (80,82) derart angeordnet werden, dass eine Vorwölbung von zumindest einem der Substrate (10,20) verringert wird.

14. Verfahren nach einem der Ansprüche 9 bis 13, wobei die Kraft F zum Herstellen der Sinterverbindungen kontinuierlich aufgebracht wird, bis die Sinterverbindungen beiden Ebenen fertiggestellt sind.

15. Verfahren nach einem der Ansprüche 9 bis 14, wobei vom Aufbringen der Kraft F bis zum Fertigstellen aller Sinterverbindungen (31,32) in allen Ebenen maximal 180s vergehen.
